# EUROPEAN PATENT APPLICATION

(11) **EP 4 678 958 A1**
(43) Date of publication of application: **14.01.2026**
(21) Application number: 25187879.9
(22) Date of filing: 07.07.2025
(51) Int. Cl.: F16K 1/22, F16K 25/00, F16K 37/00, F16K 49/00, F16K 51/02, H01L 21/67

(54) **FLOW RATE CONTROLLER, SUBSTRATE PROCESSING APPARATUS, METHOD OF MANUFACTURING SEMICONDUCTOR DEVICE, AND PROGRAM**

(30) Priority: 11.07.2024 JP 2024111657
(71) Applicant: Kokusai Electric Corporation, Tokyo 101-0045 (JP)
(72) Inventor: SHOJI, Takuto, Toyama-shi, Toyama, 939-2393 (JP); YAMAMOTO, Kaoru, Toyama-shi, Toyama, 939-2393 (JP)
(74) Representative: Bardehle Pagenberg Partnerschaft mbB Patentanwälte Rechtsanwälte

(57) **Abstract**

A technique includes a valve body (58) rotatably supported about an axis intersecting with a direction of a gas flow in a flow path for a process gas at least partially formed by a pipe (52A, 52B), said valve body (58) being heated to a higher temperature than the pipe (52A, 52B), and configured such that an emissivity of at least a portion of a surface of the valve body (58) is set to be equal to or lower than an emissivity of an inner surface of the pipe (52A, 52B); and a driver (90) configured to rotate the valve body (58) to change an opening degree of the flow path.

## Description

### CROSS-REFERENCE TO RELATED APPLICATION

This application is based upon and claims the benefit of priority from Japanese Patent Application No. 2024-111657 filed on July 11, 2024, the entire contents of which are incorporated herein by reference.

### TECHNICAL FIELD

The present disclosure relates to a flow rate controller, a substrate processing apparatus, a method of manufacturing a semiconductor device, and a program.

### BACKGROUND

In the related art, as a process of manufacturing a semiconductor device (substrate processing process), a flow rate of a process gas in a flow path for the process gas may be controlled by using a mechanism including a valve body that rotates about an axis intersecting with a direction of a gas flow in the flow path.

### SUMMARY

Some embodiments of the present disclosure provide a technique capable of preventing a foreign matter from adhering to a valve body.

According to embodiments of the present disclosure, there is provided a technique that includes a valve body rotatably supported about an axis intersecting with a direction of a gas flow in a flow path for a process gas at least partially formed by a pipe, heated to a higher temperature than the pipe, and configured such that an emissivity of at least a portion of a surface of the valve body is set to be equal to or lower than an emissivity of an inner surface of the pipe; and a driver configured to rotate the valve body to change an opening degree of the flow path.

### BRIEF DESCRIPTION OF DRAWINGS

The accompanying drawings, which are incorporated in and constitute a part of the specification, illustrate embodiments of the present disclosure.
FIG. 1 is a schematic diagram showing an overall configuration of a substrate processing apparatus according to embodiments.
FIG. 2A is a cross-sectional view of a flow rate controller in a plane perpendicular to a gas flow direction when an opening degree of a butterfly valve of the flow rate controller shown in FIG. 1 is 0%. FIG. 2B is a cross-sectional view of the flow rate controller in the gas flow direction when the opening degree of the butterfly valve of the flow rate controller shown in FIG. 1 is 0%.
FIG. 3A is a cross-sectional view of the flow rate controller in the plane perpendicular to the gas flow direction when the opening degree of the butterfly valve of the flow rate controller shown in FIG. 1 is 100%. FIG. 3B is a cross-sectional view of the flow rate controller in the gas flow direction when the opening degree of the butterfly valve of the flow rate controller shown in FIG. 1 is 100%.
FIG. 4A is a front view of the butterfly valve. FIG. 4B is a side view of the butterfly valve.
FIG. 5 is a cross-sectional view taken along the gas flow direction, showing a configuration of a heating mechanism used in the flow rate controller shown in FIG. 2A.
FIG. 6 is a cross-sectional view taken along the gas flow direction, showing a configuration of a heating mechanism according to another embodiment used in the flow rate controller shown in FIG. 2A.
FIG. 7 is a diagram for explaining transfer of heat in the flow rate controller.
FIG. 8A is an image view showing a cross section near a surface of the butterfly valve with a metallic luster film. FIG. 8B is an image view showing a cross section near a surface of the butterfly valve with a high transmittance film.
FIG. 9A is a diagram showing results of a simulation of relationships among an emissivity of a surface of the butterfly valve, a position in the butterfly valve, and a temperature. FIG. 9B shows the results of FIG. 9A in a table format.
FIG. 10 is a flowchart showing a substrate processing process applied in the embodiments.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

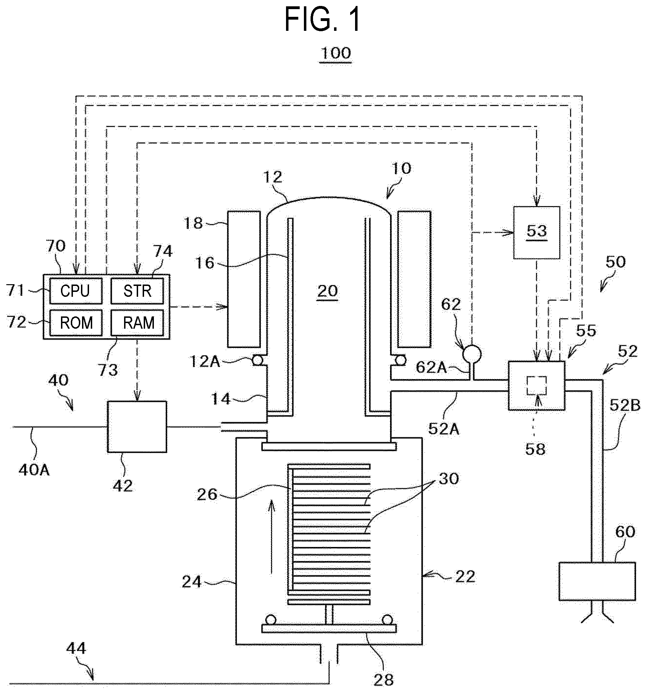

Hereinafter, embodiments of the present disclosure are described mainly with reference to FIGS. 1 to 10. Drawings used in the following description are schematic, and the dimensional relationship of respective elements, the proportion of respective elements, and the like shown in the drawings may not match the actual ones. Furthermore, the dimensional relationship of respective elements, the proportion of respective elements, and the like may not match among multiple drawings. Unless otherwise specified in the specification, each element is not limited to one, and may be present in multiple. In multiple drawings, substantially the same elements are designated by the same reference numerals, and the description of an element described with reference to one drawing is omitted in other drawings.

### (1) Configuration of the Substrate Processing Apparatus

As shown in FIG. 1, the substrate processing apparatus 100 includes a reaction furnace 10 including a process chamber 20 configured to process wafers 30 as substrates, a standby chamber 22 configured to store a boat 26 for holding the wafers 30, a gas introduction line 40 configured to introduce a gas into the process chamber 20, an exhaust system 50 configured to exhaust a gas from the process chamber 20, and a main controller 70 configured to control operations of the substrate processing apparatus 100.

### [Reaction Furnace]

In the reaction furnace 10, the process chamber 20 including a reaction tube 12 and a furnace opening flange 14 is formed. The reaction tube 12 is formed in a cylindrical shape with an axis extending in a vertical direction. The furnace opening flange 14 is connected to a lower portion of the reaction tube 12 with an airtight member 12A interposed therebetween, and is formed in a cylindrical shape with an axis extending in the vertical direction. In the reaction furnace 10, an inner tube 16 is supported concentrically with the reaction tube 12 inside the reaction tube 12. In addition, a heater 18 is provided on an outer periphery of the reaction tube 12 concentrically with the axis of the reaction tube 12 at an interval from an outer surface of the reaction tube 12. The heater 18 possesses a function of generating heat upon receiving a signal from the main controller 70 and heating the reaction tube 12. In this way, the reaction furnace 10 includes the reaction tube 12, the furnace opening flange 14, the inner tube 16, the heater 18, and the process chamber 20. In addition, the wafers 30 are disposed in the process chamber 20 and processed by a process gas.

### [Standby chamber]

The standby chamber 22 includes a transfer housing 24. The transfer housing 24 is in fluid communication with a lower portion of the furnace opening flange 14. Inside the transfer housing 24, a boat 26 for loading the wafers 30, transferring the wafers 30 and inserting the wafers 30 into the process chamber 20 is stored. A furnace opening cover 28 is provided to be movable in the vertical direction, and is configured to airtightly close the transfer housing 24 when it reaches an upper end. The boat 26 is loaded on the furnace opening cover 28 and is introduced into the reaction furnace 10 in accordance with movement of the furnace opening cover 28. In addition, a second gas introduction line 44 with the same configuration as the gas introduction line 40 described later is in fluid communication with a lower portion of the transfer housing 24. This allows the standby chamber 22 to be filled with an atmosphere in which native oxide films and the like are unlikely to be formed on the wafers 30.

### [Gas Introduction Line]

The gas introduction line 40 includes a gas introduction pipe 40A configured to bring a gas supply source (not shown) into fluid communication with the furnace opening flange 14, and a flow rate control device 42 provided between the gas supply source of the gas introduction pipe 40A and the furnace opening flange 14. The flow rate control device 42 possesses a function of opening and closing a valve (not shown) provided therein in response to a signal from the main controller 70 so as to control an amount of gas introduced. The number of gas introduction lines 40 is the same as the number of gas supply sources. The second gas introduction line 44 includes the same configuration as the gas introduction line 40, except that it brings a gas supplier into fluid communication with the lower portion of the transfer housing 24. The gas used herein is an inert gas.

### [Main Controller]

The main controller 70 is a controller (control part) that controls an overall operation of the substrate processing apparatus 100, and includes a CPU 71, a ROM 72, a RAM 73, a storage (STR) 74, and the like, each of which includes a built-in computer connected to a bus. A memory such as the storage 74 is configured as a computer-readable recording medium, and stores substrate processing programs (also called program products) described later. The main controller 70 may acquire pressure information from a pressure sensor 62 and transmit a target pressure value to a valve controller 53. The main controller 70 executes the substrate processing programs for performing various processes in the substrate processing apparatus 100 based on input information from an input part (not shown). For example, the main controller 70 is configured to be capable of executing a process recipe, which is one of the substrate processing programs, and executing a substrate processing process, which is one process for manufacturing a semiconductor device, in the substrate processing apparatus 100. At this time, the main controller 70 regulates an opening degree of a butterfly valve (valve body) 58 of an exhaust system 50 through the valve controller 53, and controls a pressure in the process chamber 20. The valve controller 53 corresponds to, for example, an automatic pressure controller (APC). IN addition, the main controller 70 controls external heaters 91 and 92 and internal heaters 93 to 95, which are described later, based on temperatures measured by thermometers 101 to 105, which are described later. The programs may also be provided to the main controller 70 by using a communication means such as the Internet or a dedicated line, without using the storage 74 or the like.

### [Exhaust System]

The exhaust system 50 includes an exhaust line 52 including at least pipes 52A and 52B connected to the process chamber 20 to discharge a gas from the process chamber 20, a pressure sensor 62 installed at the pipe 52A to detect the pressure in the process chamber 20, and a flow rate controller 55 installed between the pipes 52A and 52B. The pipes 52A and 52B are pipes that bring the process chamber 20 and the vacuum pump 60 into fluid communication with each other and form a vacuum exhaust flow path. A flow end portion, which is an end portion of the exhaust line 52 opposite to the process chamber 20, is connected to a suction side of the vacuum pump 60. The vacuum pump 60 is in an ultimate vacuum of about 10 Pa and is constantly operated to maintain a downstream of the exhaust line 52 in a vacuum state. The vacuum pump 60 and the valve controller 53 may be included in the exhaust system 50.

### [Flow Rate Controller]

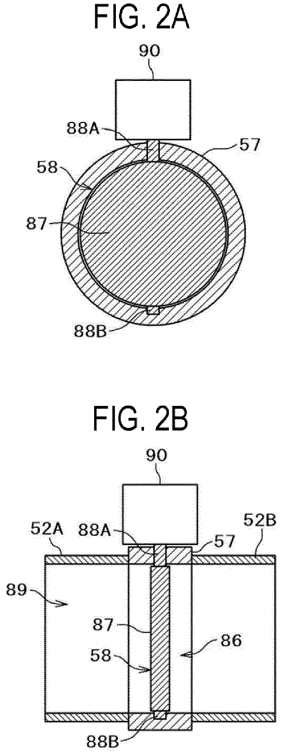

As shown in FIGS. 2A and 2B, the flow rate controller 55 includes a valve box 57, the butterfly valve 58 provided in the valve box 57, and a driver 90. The driver 90 is electrically connected to the valve controller 53 and is configured to perform an operation of controlling the opening degree of the butterfly valve 58 based on a signal from the valve controller 53.

The valve box 57 is provided between the pipes 52A and 52B, and a cylindrical through-hole 86 is formed to bring the two pipes 52A and 52B into fluid communication with each other. The pipes 52A and 52B and the valve box 57 constitute a flow path 89 for process gases. In other words, the valve box 57 constitutes a portion of the flow path 89. As used herein the term "process gases" refers to gases (e.g., a precursor gas and a reaction gas) that flow from the gas introduction line 40 to the exhaust line 52 through the process chamber 20 during the substrate processing described later. Also, the pipes 52A and 52B may not be divided, and the valve box 57 may be provided so as to be covered by an outer surface of the pipes. In this case, the butterfly valve 58 is installed in the pipes.

The butterfly valve 58 includes a valve plate 87 formed in a shape corresponding to the through-hole 86 of the valve box 57, and a shaft 88 for rotating the valve plate 87. The butterfly valve 58 is provided in the through-hole 86 and is rotatably supported about an axis extending in a direction (e.g., a vertical direction) intersecting with a direction in which a gas flows in the flow path 89 (i.e., a direction extending along the flow path 89 or a downstream direction of the flow path 89). Specifically, the valve plate 87 of the butterfly valve 58 is formed, for example, in a disk shape, and the shaft 88 is connected so as to pass through a center of the disk. In other words, the valve box 57 supports the butterfly valve 58 rotatably.

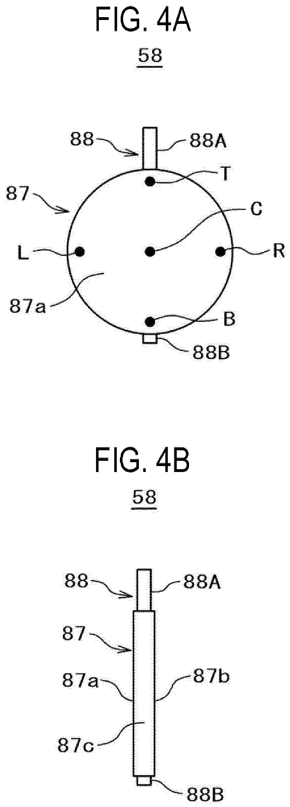

As shown in FIGS. 4A and 4B, the valve plate 87 includes a circular first surface 87a, a second surface 87b on a rear side of the first surface 87a, and a third surface (side surface) 87c located between the first surface 87a and the second surface 87b. The third surface 87c is formed with a smaller area than the first surface 87a and the second surface 87b.

The shaft 88 includes an upper shaft 88A penetrating an upper portion of the valve box 57 and connected to an upper portion of the butterfly valve 58, and a lower shaft 88B supported in a hole provided at a lower portion of the valve box 57 and connected to a lower portion of the butterfly valve 58. The shaft 88 is rotatable about an axis thereof.

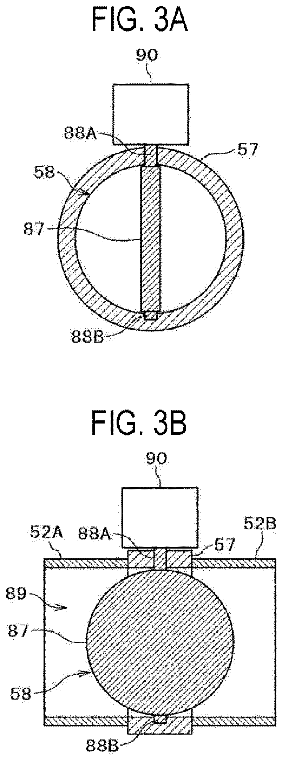

As the shaft 88 rotates, the butterfly valve 58 also rotates, which makes it possible to open and close the butterfly valve 58 and to regulate the opening degree thereof. As shown in FIGS. 2A and 2B, when the first surface 87a and the second surface 87b of the valve plate 87 are perpendicular to a flow path direction, the opening degree is minimum. As shown in FIGS. 3A and 3B, when the first surface 87a and the second surface 87b of the valve plate 87 are parallel to the flow path direction, the opening degree is maximum.

The driver 90 is a drive source that drives the shaft 88 to rotate about the axis thereof. As the driver 90, for example, a pulse motor or a servo motor is used to realize an arbitrary opening degree of the butterfly valve 58.

### [Pressure Sensor]

As shown in FIG. 1, the pressure sensor 62 is provided in fluid communication with a side toward the process chamber 20 from an installation position of the flow rate controller 55 by a pipe 62A. The pressure sensor 62 is electrically connected to the main controller 70 and possesses a function of transmitting the pressure information of the process chamber 20. The pressure sensor 62 is also connected to the pipe 52A by the pipe 62A.

The valve controller 53 calculates a target opening degree based on a target pressure of the process chamber 20 provided by the main controller 70 and an actual pressure measured by the pressure sensor 62. The target opening degree that corresponds to a conductance of the entire flow rate controller 55 is constantly updated by a method such as feedback control so that a deviation between the target pressure and the actual pressure becomes zero. If an upper limit for a pressure change rate is specified, even when a target pressure that changes at a rate exceeding the pressure change rate is inputted, the target pressure is internally corrected so as to fall within the pressure change rate. The valve controller 53 also outputs an opening degree command to the driver 90 according to the target opening degree. The opening degree command may be given, for example, as a relative opening degree when the full opening of the butterfly valve 58 is set to be 100%. The full closing of the butterfly valve 58 is set to be 0%.

### [Heating Mechanism]

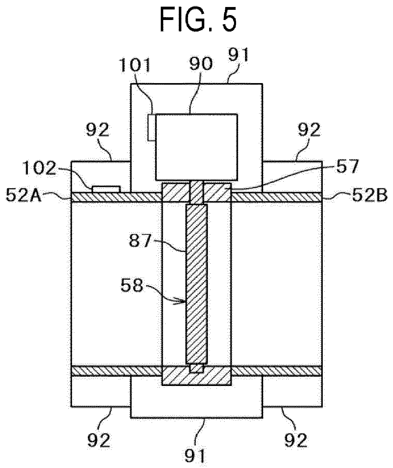

As shown in FIG. 5, the external butterfly valve heater 91 is installed to cover the valve box 57 and the driver 90, and the external pipe heater 92 is installed to cover the pipes 52A and 52B. The external butterfly valve heater 91 and the external pipe heater 92 are, for example, jacket heaters. The external butterfly valve heater 91 heats a portion of the flow rate controller 55. In addition, the thermometer 101 is installed on an upper side surface of the driver 90, and the thermometer 102 is installed on an outer surface of the pipe 52A. The valve plate 87 is heated by heating the valve box 57 and the driver 90 with the external butterfly valve heater 91. The driver 90 may not be heated by the external butterfly valve heater 91.

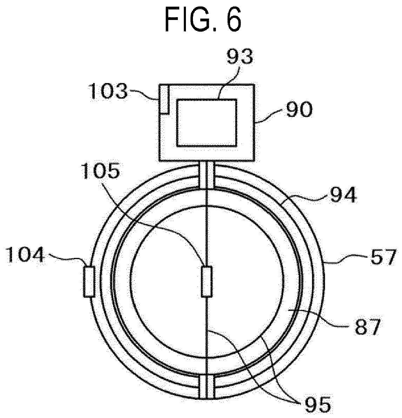

Alternatively, as shown in FIG. 6, the internal driver heater 93 that heats an inside of the driver 90, the internal valve box heater 94 that heats an inside of the valve box 57, and the internal valve body heater 95 that heats an inside of the valve plate 87 are installed. In addition, the thermometer 103 is installed on the upper side surface of the driver 90, the thermometer 104 is provided on an outer surface of the valve box 57, and the thermometer 105 is provided on a surface of the valve plate 87. The internal driver heater 93 may be omitted so that the driver 90 is not heated.

### [Operation and Effect]

The lower the temperatures of the butterfly valve 58 and the pipes 52A and 52B that make up the exhaust system 50, the more easily a foreign matter originating from the process gas adheres to the surfaces. In addition, since the butterfly valve 58 blocks the flow of the process gas in the flow path, the process gas tends to stagnate or becomes turbulent around the butterfly valve 58. Thus, a foreign matter is more likely to adhere to the butterfly valve 58 than to the pipes 52A and 52B or the like.

For this reason, it is preferable that the temperature of the butterfly valve 58 is higher than the temperatures of the pipes 52A and 52B. In the embodiments, the butterfly valve 58 is heated by the heating mechanism to a temperature higher than those of the pipes 52A and 52B.

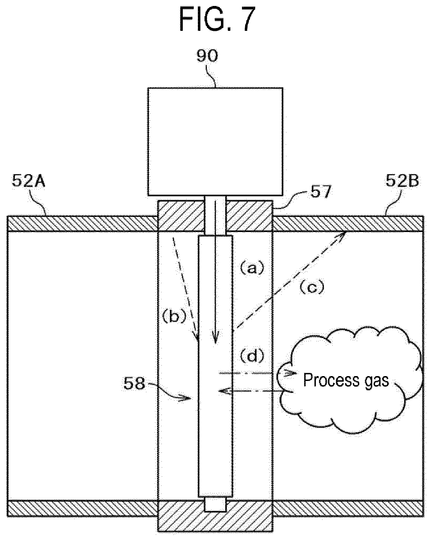

The external butterfly valve heater 91 heats the valve box 57 to a temperature higher than that of the butterfly valve 58. As a result, as indicated by the dashed arrow (b) in FIG. 7, it is possible for the butterfly valve 58 to be heated by thermal radiation and thermal conduction from the valve box 57 to the butterfly valve 58. Therefore, it is possible to further suppress a decrease in the temperature of the butterfly valve 58.

In the heating mechanism shown in FIG. 6, the butterfly valve 58 is heated by the internal valve body heater 95 so that the butterfly valve 58 is in a higher temperature than the pipes 52A and 52B. The internal driver heater 93 and the internal valve box heater 94 heat the driver 90 and the valve box 57 so that they are in a higher temperature than the butterfly valve 58. The internal driver heater 93 may be omitted, the valve box 57 may be heated to a higher temperature than the butterfly valve 58, and the driver 90 may be heated to a lower temperature than the butterfly valve 58. In addition, either the heating mechanism shown in FIG. 5 or the heating mechanism shown in FIG. 6 may be used, or both the heating mechanism shown in FIG. 5 and the heating mechanism shown in FIG. 6 may be used.

Since the temperature of the butterfly valve 58 is made higher than the temperatures of the pipes 52A and 52B, heat radiation occurs from the butterfly valve 58 toward the pipes 52A and 52B as indicated by the dashed arrow (c) in FIG. 7. This causes the temperature of the butterfly valve 58 to drop. In addition, the temperature of the butterfly valve 58 becomes higher or lower than a temperature of the process gas depending on the substrate processing. For this reason, convection heat conduction occurs between the butterfly valve 58 and the process gas as indicated by the dashed arrow (d) in FIG. 7. When the temperature of the butterfly valve 58 becomes higher than the temperature of the process gas, the temperature of the butterfly valve 58 drops. For these reasons, it is preferable to reduce an emissivity of the butterfly valve 58 so that thermal energy of the butterfly valve 58 is less likely to be released by thermal radiation.

As used herein, the term "emissivity" refers to a ratio of light energy (radiance) emitted by an object at a certain temperature through thermal radiation to light energy (blackbody radiation) emitted by a black body at the same temperature, which is taken as 1. The emissivity is a value (dimensionless quantity) between 0 and 1, and differs depending on the material and the wavelength of light. If the emissivity is high, reflectance is low, and conversely, if the emissivity is low, the reflectance is high.

In the embodiments, for example, an emissivity of at least a portion of a surface of the butterfly valve 58 is set to be equal to or lower than an emissivity of inner surfaces of the pipes 52A and 52B. More preferably, the emissivity of at least a portion of the surface of the butterfly valve 58 is set to be lower than the emissivity of the inner surfaces of the pipes 52A and 52B. This suppresses heat radiation from the butterfly valve 58 to the pipes 52A and 52B, which makes it possible to suppress a decrease in the temperature of the butterfly valve 58.

Herein, since the shaft 88 is formed with a smaller surface area than the valve plate 87, a temperature drop due to thermal radiation is unlikely to occur. Further, unlike the valve plate 87, the shaft 88 is in direct contact with the valve box 57, and thus it is easily heated by thermal conduction from the valve box 57. For these reasons, a magnitude of an emissivity of a surface of the shaft 88 contributes less to the temperature drop of the butterfly valve 58 than a magnitude of an emissivity of the surface of the valve plate 87. Therefore, the emissivity of the surface of the shaft 88 may be set to be equal to or higher than the emissivity of the surface of the valve plate 87. More preferably, the emissivity of the surface of the shaft 88 may be set to be higher than the emissivity of the surface of the valve plate 87. Further, the emissivity of the surface of the shaft 88 may be set to be equal to or higher than the emissivity of the inner surfaces of the pipes 52A and 52B. More preferably, the emissivity of the surface of the shaft 88 may be set to be higher than the emissivity of the inner surfaces of the pipes 52A and 52B. In these cases, the processing for reducing the emissivity of the surface of the shaft 88 may be omitted or simplified, which makes it possible to reduce a manufacturing cost of the flow rate controller 55.

An emissivity of at least a portion of an inner surface of the valve box 57 may be set to be equal to or higher than the emissivity of the surface of the butterfly valve 58. More preferably, the emissivity of at least a portion of the inner surface of the valve box 57 may be set to be higher than the emissivity of the surface of the butterfly valve 58. This may promote the radiation of heat from the valve box 57 to the butterfly valve 58. Accordingly, the temperature drop of the butterfly valve 58 may be further suppressed.

The emissivity of at least a portion of the inner surface of the valve box 57 may be set to be equal to or higher than an emissivity of surfaces of the pipes 52A and 52B. More preferably, the emissivity of at least a portion of the inner surface of the valve box 57 may be set to be higher than the emissivity of the surfaces of the pipes 52A and 52B. This may promote the radiation of heat from the valve box 57 to the butterfly valve 58. Accordingly, the temperature drop of the butterfly valve 58 may be suppressed.

The emissivity of at least a portion of the surface of the valve plate 87 may be set to be equal to or lower than the emissivity of the inner surfaces of the pipes 52A and 52B. More preferably, the emissivity of at least a portion of the surface of the valve plate 87 may be set to be lower than the emissivity of the inner surfaces of the pipes 52A and 52B. The valve plate 87 is formed with a larger surface area than the shaft 88, and is less likely to be heated by thermal conduction. Therefore, by setting the emissivity of at least a portion of the surface of the valve plate 87 to be equal to or lower than the emissivity of the inner surfaces of the pipes 52A and 52B, it becomes easier to suppress the temperature drop of the butterfly valve 58.

When setting the emissivity of at least a portion of the surface of the valve plate 87 equal to or lower than the emissivity of the inner surfaces of the pipes 52A and 52B, the following two examples may be adopted.

As an example, an emissivity of at least a portion of the first surface 87a and at least a portion of the second surface 87b of the valve plate 87 is set to be equal to or lower than an emissivity of the third surface 87c. More preferably, the emissivity of at least a portion of the first surface 87a and at least a portion of the second surface 87b of the valve plate 87 is set to be lower than the emissivity of the third surface 87c. Since the first surface 87a and the second surface 87b of the valve plate 87 are formed with larger surface areas than the third surface 87c, thermal radiation is more likely to occur. Therefore, by setting the emissivity of at least a portion of the first surface 87a and at least a portion of the second surface 87b to be equal to or lower than the emissivity of the third surface 87c, it becomes easier to suppress the temperature drop of the butterfly valve 58. Further, in such a case, a processing for lowering the emissivity of the third surface 87c of the butterfly valve 58 may be omitted, or a processing content for the third surface 87c may be simplified compared to processing contents for the first surface 87a and the second surface 87b. Accordingly, the manufacturing cost of the butterfly valve 58 may be reduced.

As another example, an emissivity of the entire first surface 87a and the entire second surface 87b is set to be equal to or lower than the emissivity of the inner surfaces of the pipes 52A and 52B. More preferably, the emissivity of the entire first surface 87a and the entire second surface 87b is set to be lower than the emissivity of the inner surfaces of the pipes 52A and 52B. Since the first surface 87a and the second surface 87b of the valve plate 87 are formed with larger surface areas than the third surface 87c, thermal radiation is more likely to occur. Therefore, by setting the emissivity of at least a portion of the first surface 87a and at least a portion of the second surface 87b to be equal to or lower than the emissivity of the inner surfaces of the pipes 52A and 52B, it is easier to suppress the temperature drop of the butterfly valve 58. An emissivity of at least a portion of the third surface 87c may be set to be equal to or lower than the emissivity of the inner surfaces of the pipes 52A and 52B. This makes it easier to suppress the temperature drop of the butterfly valve 58.

Several examples of lowering an emissivity of a portion of the surface of the butterfly valve 58 are described below.

As a first example, at least a portion of the surface of the butterfly valve 58 is electrolytically polished. As a result, it is possible to lower the emissivity. Furthermore, this may suppress corrosion of the surface of the butterfly valve 58 caused by the process gas or a cleaning gas. Therefore, it is possible to reduce a frequency of replacing the butterfly valve 58.

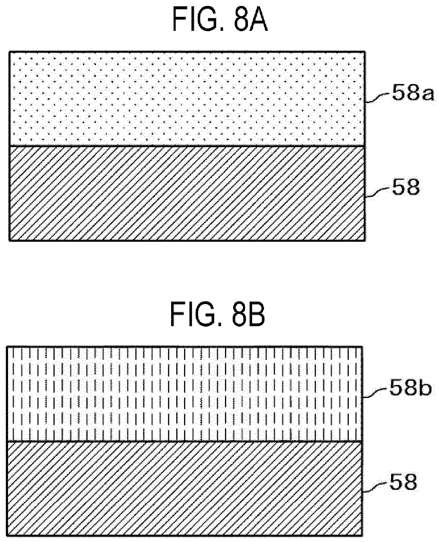

As a second example, as shown in FIG. 8A, a film 58a with metallic luster is formed on at least a portion of the surface of the butterfly valve 58. For example, a film 58a with metallic luster and containing at least one selected from the group of metal elements such as nickel (Ni), chromium (Cr), and iron (Fe) is formed on at least a portion of the surface of the butterfly valve 58. This may lower the emissivity of the surface of the butterfly valve 58. The film 58a with metallic luster may contain fluorine. Substances containing fluorine possess high chemical resistance. This may suppress corrosion of the film with metallic luster and the valve body caused by the process gas or cleaning gas.

As a third example, as shown in FIG. 8B, a high transmittance film 58b that transmits electromagnetic waves is formed on at least a portion of the surface of the butterfly valve 58. By forming the high transmittance film 58b on at least a portion of the butterfly valve 58, it is possible to suppress corrosion of the surface of the butterfly valve 58 caused by the process gas, cleaning gas, or the like. Therefore, the frequency of replacing the butterfly valve 58 may be reduced. In addition, since the high transmittance film does not easily absorb electromagnetic waves radiated from an outside to the butterfly valve 58, it is difficult to increase the emissivity of the butterfly valve 58. The high transmittance film 58b may contain fluorine. Substances containing fluorine possess high chemical resistance. Therefore, it is possible to suppress corrosion of the metal-containing film and the butterfly valve 58 caused by the process gas or cleaning gas. The high transmittance film 58b may include an amorphous film of silicon oxide. The amorphous film of silicon oxide tends to transmit easily electromagnetic waves and possesses high chemical resistance. Accordingly, it is possible to suppress corrosion of the metal-containing film and the valve body caused by the process gas or cleaning gas.

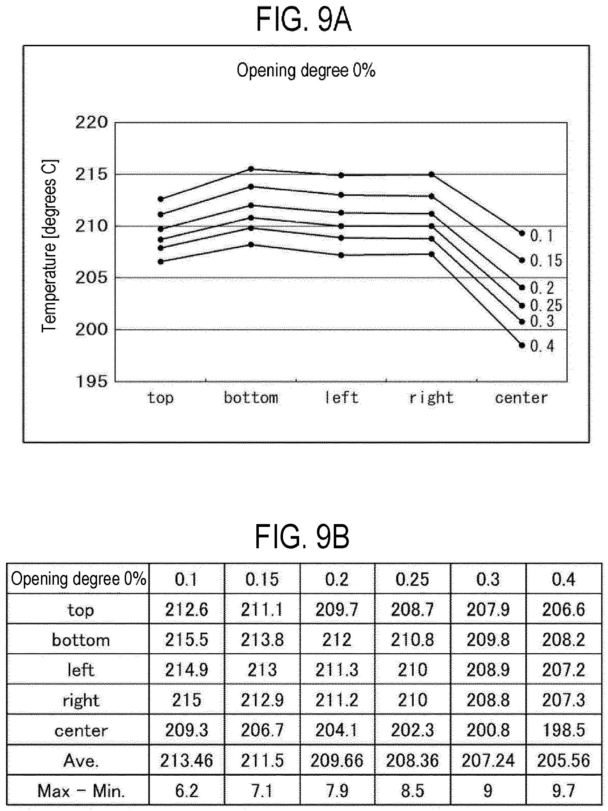

Results of a simulation of the relationship between the emissivity and temperature of the surface of the butterfly valve 58 in the flow rate controller shown in FIGS. 2A and 2B are described with reference to FIGS. 9A and 9B.

The horizontal axis in FIG. 9A represents a position on the first surface 87a or the second surface 87b of the valve plate 87 of the butterfly valve 58. "Top", "bottom", "left", "right" and "center" respectively correspond to a position T, a position B, a position L, a position R, and a position C on the first surface 87a shown in FIG. 4A. The vertical axis in FIG. 9A represents the temperature of the butterfly valve 58. FIG. 9A shows temperatures (degrees C) when the emissivity is "0.1", "0.15", "0.2", "0.25", "0.3" and "0.4". FIG. 9B shows a table indicating temperatures (degrees C) of the top, bottom, left, right and center, average temperatures (Ave.) of the temperatures (degrees C) at these five points, and differences (Max-Min) between maximum and minimum temperatures at these five points for each of the six emissivities in FIG. 9A.

Simulation conditions are as follows.
Temperature of valve box 57: 230 degrees C
Emissivity of surface of valve box 57: 0.25
Opening degree of butterfly valve 58: 0%
Material of valve box 57 and butterfly valve 58: SUS
Temperature of pipes 52A and 52B: 180 degrees C
Emissivity of inner surfaces of pipes 52A and 52B: 0.25
Material of pipes 52A and 52B: SUS

Compared to the case where the emissivity of the butterfly valve 58 is higher than the emissivity (0.25) of the inner surfaces of the pipes 52A and 52B, when the emissivity is equal to or lower than the emissivity (0.25) of the inner surfaces of the pipes 52A and 52B, the temperature difference between a lowest temperature point (Center) and other points is small. That is, by making the emissivity of the butterfly valve 58 equal to or lower than the emissivity of the inner surfaces of the pipes 52A and 52B, occurrence of cold spots (points with lower temperatures than other points) in the butterfly valve 58 is suppressed. In this case, the average temperature of the butterfly valve 58 is also high. That is, by making the emissivity of the butterfly valve 58 equal to or lower than the emissivity of the inner surfaces of the pipes 52A and 52B, it is possible to reduce an amount of energy consumed by the external butterfly valve heater 91 and the internal valve body heater 95.

As shown in FIGS. 9A and 9B, the lower the emissivity of the surface of the butterfly valve 58, the higher the temperature of the butterfly valve 58 is. The temperature of the butterfly valve 58 is lower than the temperature of the valve box 57 and higher than the temperatures of the pipes 52A and 52B. From the viewpoint of suppressing the temperature drop of the butterfly valve 58, the lower the emissivity, the more preferable it is. However, the lower the emissivity, the higher the cost of surface treatment of the butterfly valve 58.

The emissivity of at least a portion of the surface of the butterfly valve 58 is preferably 0.05 or more and 0.25 or less. When the emissivity of the butterfly valve 58 is higher than 0.25, the temperature of the butterfly valve 58 is likely to decrease. When the emissivity of the butterfly valve 58 is less than 0.05, the cost of surface treatment of the butterfly valve 58 increases compared to the effect of suppressing the temperature drop of the butterfly valve 58. Further, as shown in FIGS. 9A and 9B, when the emissivity of the surface of the butterfly valve 58 is 0.25 or less, an extent of change in the temperature of the butterfly valve 58 relative to an extent of change in the emissivity of the surface of the butterfly valve 58 is greater than when the emissivity of the surface of the butterfly valve 58 is higher than 0.25. Accordingly, when the emissivity is 0.05 or more and 0.25 or less, the effect of suppressing the temperature drop of the butterfly valve 58 may be obtained while suppressing an excessive increase in the cost of surface treatment of the butterfly valve 58.

It is more preferable that the emissivity of at least a portion of the surface of the butterfly valve 58 is 0.08 or more and 0.20 or less. As shown in FIGS. 9A and 9B, when the emissivity of the surface of the butterfly valve 58 is 0.20 or less, the extent of change in the temperature of the butterfly valve 58 relative to the extent of change in the emissivity of the surface of the butterfly valve 58 is greater than when the emissivity of the surface of the butterfly valve 58 is higher than 0.20. Accordingly, when the emissivity is 0.08 or more and 0.20 or less, it is possible to sufficiently obtain the effect of suppressing the temperature drop of the butterfly valve 58 while suppressing the increase in the cost of surface treatment of the butterfly valve 58.

It is even more preferable that the emissivity of at least a portion of the surface of the butterfly valve 58 is 0.09 or more and 0.15 or less. As shown in FIGS. 9A and 9B, when the emissivity of the surface of the butterfly valve 58 is 0.15 or less, the extent of change in the temperature of the butterfly valve 58 relative to the extent of change in the emissivity of the surface of the butterfly valve 58 is larger than when the emissivity of the surface of the butterfly valve 58 is higher than 0.15. Accordingly, when the emissivity of the surface of the butterfly valve 58 is 0.09 or more and 0.15 or less, it is possible to further increase the effect of suppressing the temperature drop of the butterfly valve 58 while further suppressing the increase in the cost of surface treatment of the butterfly valve 58.

### (2) Substrate Processing Process

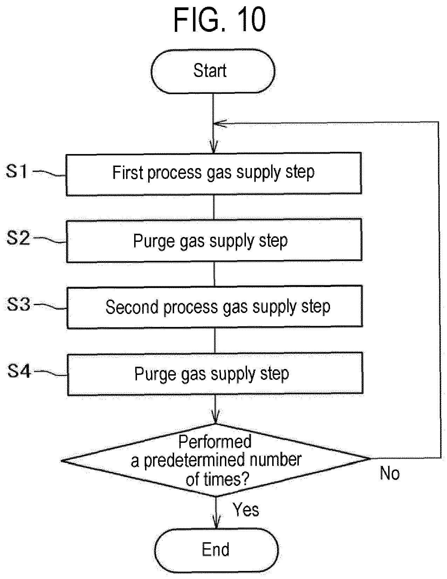

An example of a process for forming a film on the wafer 30 by processing the wafer 30 in the process chamber 20 with one or more types of process gas as one of processes of manufacturing a semiconductor device by using the substrate processing apparatus 100 is described with reference to FIG. 10. In the following description, the operation of each component constituting the substrate processing apparatus 100 is controlled by the main controller 70.

In the substrate processing process of the embodiments, a cycle including a step of supplying a first process gas as one of the process gases to the wafer 30 accommodated in the process container (in the process chamber 20) and a step of supplying a second process gas as one of the process gases to the wafer 30 is performed a predetermined number of times (n times where n is an integer of 1 or more) to form a film on the wafer 30. Specifically, a cycle including a step of supplying a silicon (Si)-containing gas as the first process gas to the wafer 30 and a step of supplying a nitriding gas as the second process gas to the wafer 30 is performed a predetermined number of times (n times where n is an integer of 1 or more) to form a silicon nitride film (SiN film) on the wafer 30.

When a film-forming gas is supplied into the process chamber 20 as the process gas and a film is formed on a surface of an object such as the wafer 30 or the like in the process chamber 20, a film as a foreign matter originated from the process gas may also adhere to the surface of the butterfly valve 58. Thus, even when the butterfly valve 58 is provided in the pipe through which the film-forming gas as the process gas flows, it is possible to use the technique disclosed herein to suppress the temperature drop of the butterfly valve 58, thereby suppressing adhesion of the foreign matter originated from the process gas to the butterfly valve 58.

When a vaporized gas obtained by vaporizing a substance kept in a solid or liquid state under standard conditions is used as part of the process gases, the solidified or liquefied vaporized gas may adhere to the surface of the butterfly valve 58 as the foreign matter originated from the process gas. Thus, even when the butterfly valve 58 is provided in the pipe through which the vaporized gas flows as the process gas, it is possible to use the technique disclosed herein to suppress the temperature drop of the butterfly valve 58, thereby suppressing the adhesion of the foreign matter originated from the process gas to the butterfly valve 58.

The term "wafer" used herein may refer to a wafer itself or a stacked body of the wafer and a predetermined layer or film formed on a surface of the wafer. The phrase "a surface of a wafer" used herein may refer to the surface of the wafer itself or a surface of a predetermined layer or the like formed on the wafer. The expression "a predetermined layer is formed on a wafer" used herein may mean that the predetermined layer is directly formed on the surface of the wafer itself or that the predetermined layer is formed on a layer or the like formed on the wafer. The term "substrate" used herein may be synonymous with the term "wafer."

### (Wafer Charging and Boat Loading)

When multiple wafers 30 are charged to the boat 26 (wafer charging), the boat 26 supporting the multiple wafers 30 is lifted by a boat elevator and loaded into the process chamber 20 (boat loading). In this state, the furnace opening cover 28 seals a lower end of the furnace opening flange 14 via an O-ring.

### (Pressure Regulation and Temperature Regulation)

Inside the process chamber 20, i.e., a space in which the wafers 30 exist, is vacuum-exhausted (exhausted into a reduced pressure) by the vacuum pump 60 so as to acquire a desired pressure (vacuum level). At this time, a pressure in the reaction tube 12 is measured by the pressure sensor 62, and the flow rate controller 55 is feedback-controlled based on the measured pressure information, i.e., the opening degree of the flow path 89 is controlled by the flow rate controller 55. As a result, the pressure in the process chamber 20 is regulated to the desired pressure. The vacuum pump 60 and the flow rate controller 55 are kept in a constantly operating state until the substrate processing is completed. In addition, the wafers 30 in the process chamber 20 are heated by the heater 18 so that the wafers 30 acquire a desired film formation temperature. At this time, a state of power supply to the heater 18 is feedback-controlled based on temperature information detected by the temperature sensor (not shown) so that an inside of the process chamber 20 acquires a desired temperature distribution. Heating of the inside of the process chamber 20 by the heater 18 is continued at least until the processing of the wafers 30 is completed.

### (Substrate Processing)

Subsequently, as the substrate processing, a first process gas supply step, a purge gas supply step, a second process gas supply step, and a purge gas supply step are executed sequentially.

### [First Process Gas Supply Step: S1]

In this step, a Si-containing gas as the first process gas and a carrier gas are supplied to the wafers 30 in the process chamber 20. By supplying the Si-containing gas to the wafers 30, a Si-containing layer is formed as a first layer on an outermost surface of each of the wafers 30.

### [Purge Gas Supply Step: S2]

After the first layer is formed, the supply of the Si-containing gas into the inner tube 16 is stopped. At this time, the butterfly valve 58 of the flow rate controller 55 is left open, the reaction tube 12 is vacuum-exhausted by the vacuum pump 60, and the Si-containing gas remaining in the process chamber 20, which is either unreacted or contributed to the formation of the first layer, is removed from the inside of the process chamber 20. At this time, the supply of the carrier gas into the process chamber 20 is maintained. The carrier gas acts as a purge gas, and may enhance the effect of discharging the gas remaining in the process chamber 20 from the inside of the process chamber 20. When the purging is completed, the supply of the carrier gas into the process chamber 20 is stopped.

### [Second Process Gas Supply Step: S3]

After step S2 is completed, a nitriding gas as the second process gas and a carrier gas are supplied to the wafers 30 in the process chamber 20. The nitriding gas supplied to the wafers 30 reacts with at least a portion of the first layer, i.e., the Si-containing layer, formed on each of the wafers 30 in step S1. This causes the first layer to be nitrided and changed (modified) into a second layer containing Si and N, i.e., a SiN layer.

### [Purge Gas Supply Step: S4]

After the second layer (SiN layer) is formed, the supply of the nitriding gas into the inner tube 16 is stopped. Then, by the same processing procedure as that of step S2, the nitriding gas and reaction by-products remaining in the process chamber 20 are removed from the inside of the process chamber 20.

### [Performing a Predetermined Number of Times]

A cycle in which the above-mentioned steps S1 to S4 are performed asynchronously, i.e., without synchronization, is performed a predetermined number of times (n times where n is an integer of 1 or more), whereby a SiN film with a predetermined thickness may be formed on the wafer 30. It is preferable to repeat the above-mentioned cycle multiple times. In other words, it is preferable to set a thickness of a second layer formed per cycle to be smaller than a desired thickness, and to repeat the above-mentioned cycle multiple times until a thickness of a film formed by stacking the second layers reaches the desired thickness.

### (After-Purge Step and Atmospheric Pressure Restoration)

After the substrate processing is completed, an inert gas is supplied into the reaction tube 12 and exhausted from the exhaust line 52. This purges the inside of the process chamber 20, and gases and reaction by-products remaining in the process chamber 20 are removed from the inside of the process chamber 20 (after-purge). Thereafter, an atmosphere in the process chamber 20 is replaced with the inert gas (inert gas replacement), and the pressure in the process chamber 20 is returned to the atmospheric pressure (atmospheric pressure restoration).

### (Boat Unloading and Wafer Discharging)

Then, the furnace opening cover 28 is lowered, the lower end of the furnace opening flange 14 is opened, and the processed wafers 30 are unloaded from the reaction tube 12 while being supported by the boat 26 (boat unloading). After being unloaded to an outside of the reaction tube 12, the processed wafers 30 are taken out from the boat 26 (wafer discharging).

According to the embodiments, the butterfly valve 58 is heated to a temperature higher than that of the pipes 52A and 52B, and the emissivity of at least a portion of the surface of the butterfly valve 58 is set to be equal to or lower than that of the inner surfaces of the pipes 52A and 52B. This makes it possible to suppress a temperature drop of the heated butterfly valve 58, thereby making it possible to suppress adhesion of a foreign matter to the butterfly valve 58.

In the above-described embodiments, there is described the example in which a film is formed using a batch-type substrate processing apparatus that processes multiple substrates at a time. The present disclosure is not limited to the above-described embodiments, and may be suitably applied to, for example, a case where a film is formed using a single-substrate-type substrate processing apparatus that processes one or several substrates at a time. In addition, in the above-described embodiments, there is described the example in which a film is formed using the substrate processing apparatus with a hot-wall-type process furnace. The present disclosure is not limited to the above-described embodiments, and may be suitably applied to a case where a film is formed using a substrate processing apparatus with a cold-wall-type process furnace.

Even when these substrate processing apparatuses are used, each processing may be performed under the same processing procedures and conditions as in the above-described embodiments, and the same effects as in the above-described embodiments may be obtained.

According to the present disclosure in some embodiments, it is possible to prevent a foreign matter from adhering to a valve body.

While certain embodiments are described, these embodiments are presented by way of example, and are not intended to limit the scope of the disclosures. Indeed, the embodiments described herein may be embodied in a variety of other forms. Furthermore, various omissions, substitutions, and changes in the form of the embodiments described herein may be made without departing from the spirit of the disclosures. The accompanying claims and their equivalents are intended to cover such forms or modifications as would fall within the scope and spirit of the disclosures.

## Claims

1. A flow rate controller (55) comprising:
a valve body (58) rotatably supported about an axis intersecting with a direction of a gas flow in a flow path for a process gas at least partially formed by a pipe (52A, 52B), heated to a higher temperature than the pipe (52A, 52B), and configured such that an emissivity of at least a portion of a surface of the valve body (58) is set to be equal to or lower than an emissivity of an inner surface of the pipe (52A, 52B); and
a driver (90) configured to rotate the valve body (58) to change an opening degree of the flow path.

2. The flow rate controller (55) of Claim 1, further comprising:
a valve box (57) configured to rotatably support the valve body (58),
wherein the valve box (57) is heated to a higher temperature than the valve body (58).

3. The flow rate controller (55) of Claim 2, wherein the valve box (57) constitutes at least a portion of the flow path, and
wherein an emissivity of at least a portion of an inner surface of the valve box (57) is set to be equal to or higher than an emissivity of the surface of the valve body (58) or to be equal to or higher than an emissivity of a surface of the pipe (52A, 52B).

4. The flow rate controller (55) of Claim 2 or Claim 3, wherein the valve body (58) includes a shaft (88) rotated by the driver (90) and a valve plate (87) provided at the shaft (88), and
wherein an emissivity of at least a portion of a surface of the valve plate (87) is set to be equal to or lower than the emissivity of the inner surface of the pipe (52A, 52B).

5. The flow rate controller (55) of Claim 4, wherein the valve plate (87) includes a first surface (87a), a second surface (87b) located on a rear side of the first surface (87a), and a third surface (87c) with a smaller area than the first surface (87a) and the second surface (87b), and
wherein an emissivity of at least a portion of the first surface (87a) and at least a portion of the second surface (87b) is set to be equal to or lower than an emissivity of the third surface (87c).

6. The flow rate controller (55) of Claim 4, wherein the valve plate (87) includes a first surface (87a), a second surface (87b) located on a rear side of the first surface (87a), and a third surface (87c) with a smaller area than the first surface (87a) and the second surface (87b), and
wherein an emissivity of the entire first surface (87a) and the entire second surface (87b) is set to be equal to or lower than the emissivity of the inner surface of the pipe (52A, 52B).

7. The flow rate controller (55) of Claim 5 or Claim 6, wherein an emissivity of at least a portion of the third surface (87c) is set to be equal to or lower than the emissivity of the inner surface of the pipe (52A, 52B).

8. The flow rate controller (55) of any one of Claims 1 to 3, wherein a high transmittance film (58b) capable of transmitting electromagnetic waves is formed on at least a portion of the surface of the valve body (58).

9. The flow rate controller (55) of Claim 8, wherein the high transmittance film (58b) contains fluorine.

10. The flow rate controller (55) of Claim 8, wherein the high transmittance film (58b) includes an amorphous film of silicon oxide.

11. The flow rate controller (55) of any one of Claims 1 to 3, wherein the emissivity of at least a portion of the surface of the valve body (58) is 0.05 or more and 0.25 or less.

12. A substrate processing apparatus (100) comprising the flow rate controller (55) of any one of Claims 1 to 11.

13. A method of manufacturing a semiconductor device, comprising:
(a) processing a substrate (30) in a process chamber (20) by a process gas; and
(b) controlling, by a flow rate controller (55), an opening degree of a flow path for the process gas at least partially formed by a pipe (52A, 52B) connected to the process chamber (20),
wherein the flow rate controller (55) includes a valve body (58) rotatably supported about an axis intersecting with a direction of a gas flow in the flow path for the process gas, heated to a higher temperature than the pipe (52A, 52B), and configured such that an emissivity of at least a portion of a surface of the valve body (58) is set to be equal to or lower than an emissivity of an inner surface of the pipe (52A, 52B), and a driver (90) configured to rotate the valve body (58) to change the opening degree of the flow path.

14. A program that causes, by a computer, a substrate processing apparatus (100) to perform a process comprising:
(a) processing a substrate (30) in a process chamber (20) by a process gas; and
(b) controlling, by a flow rate controller (55), an opening degree of a flow path for the process gas at least partially formed by a pipe (52A, 52B) connected to the process chamber (20),
wherein the flow rate controller (55) includes a valve body (58) rotatably supported about an axis intersecting with a direction of a gas flow in the flow path for the process gas, heated to a higher temperature than the pipe (52A, 52B), and configured such that an emissivity of at least a portion of a surface of the valve body (58) is set to be equal to or lower than an emissivity of an inner surface of the pipe (52A, 52B), and a driver (90) configured to rotate the valve body (58) to change the opening degree of the flow path.
